Europäisches Patentamt

European Patent Office

Office européen des brevets

(11) Veröffentlichungsnummer: **0 080 156**
**A1**

## (12) EUROPÄISCHE PATENTANMELDUNG

(21) Anmeldenummer: 82110599.6

(22) Anmeldetag: 16.11.82

(51) Int. Cl.³: **H 05 K 7/20**

(30) Priorität: 24.11.81 DE 3146504

(43) Veröffentlichungstag der Anmeldung: 01.06.83
Patentblatt 83/22

(84) Benannte Vertragsstaaten: FR GB NL

(71) Anmelder: **SIEMENS AKTIENGESELLSCHAFT, Berlin
und München Wittelsbacherplatz 2,
D-8000 München 2 (DE)**

(72) Erfinder: **Brabetz, Bernhard, Dipl.-Ing.,
Dr.-Böttcher-Strasse 33, D-8000 München 60 (DE)**
Erfinder: **Steiner, Rainer, Dipl.-Phys.,
Schneemannstrasse 1, D-8000 München 70 (DE)**
Erfinder: **Strohmayer, Josef, Dr., Tessiner Strasse 97,
D-8000 München 71 (DE)**

(54) **Kühlkonzept für Bausteine mit hoher Verlustleistung.**

(57) Die beim Betrieb von elektronischen Bausteinen, z.B. integrierten Schaltkreisen, als Wärme frei werdende Verlustleistung muß über geeignete Wärmeableitungssysteme abgeführt werden. Beim Kühlkonzept sind innerhalb der Einbauplätze Durchbrüche in der Form der zu kühlenden elektronischen Bausteine in der Leiterplatte vorgesehen, die durch einen Kühlkörper, der mit einer Kühlplatte in Verbindung steht, ausgefüllt sind. Die Bausteine sind ganzflächig gut wärmeleitend mit dem Kühlkörper verbunden.

SIEMENS AKTIENGESELLSCHAFT
Berlin und München

Unser Zeichen
VPA

0080156

81 P 7 1 7 9 E

## Kühlkonzept für Bausteine mit hoher Verlustleistung.

Die Erfindung betrifft ein Kühlkonzept für elektronische Bausteine mit hoher Verlustleistung in Verbindung mit Leiterplatten.

Im Rahmen der Miniaturisierung elektronischer Schaltkreise und zur Erhöhung der Leistungsfähigkeit von elektronischen Einbausystemen werden auf mehrlagigen Leiterplatten großintegrierte Bausteine montiert.

Die beim Betrieb der integrierten Schaltkreise als Wärme freiwerdende Verlustleistung muß über geeignete Wärmeableitungssysteme abgeführt werden, wobei wegen der hohen Packungsdichte der Bauelemente die Verlustleistungsdichte im Vergleich zu herkömmlichen Systemen beträchtlich gestiegen ist.

Zur Lösung dieses Problems wurde bereits eine Wärmeableitungsvorrichtung vorgeschlagen, bei der die integrierten Bauteile über eine gut wärmeleitende Schicht auf der Mehrlagenleiterplatte montiert sind. Unterhalb dieser Schicht sind Wärmeleitbohrungen vorgesehen, die gut wärmeleitendes Material enthalten, das auf der gegenüberliegenden Seite der Mehrlagenleiterplatte mit einer Wärmeleitfläche verbunden ist.

Aufgabe der vorliegenden Erfindung ist es, ein Kühlkonzept für mit elektronischen Bausteinen bestückte Leiterplatten zu schaffen, wobei die Zugänglichkeit zu den Bausteinen beim Betrieb des elektronischen Gerätes gewährleistet sein muß. Die Lösung dieser Aufgabe besteht darin, daß für die zu kühlenden elektronischen Bausteine Durchbrüche mindestens in der Größe von der Fläche der Bausteine in der Leiterplatte vorgesehen sind, daß in diese Durchbrüche Kühlkörper hineinragen, die Bestandteil einer flüssigkeits- oder gasgekühlten Kühlplatte sind, und daß ferner die Bausteine gut wärmeleitend ganzflächig mit dem zugeordneten Kühlkörper verbunden sind.

Durch diese Maßnahme erhält man eine Wärmeableitungsvorrichtung für Leiterplatten mit Bauteilen, die einen maximal möglichen Abtransport der Verlustwärme von einer Fläche des elektronischen Bausteines erlaubt, ohne daß die Zugänglichkeit zu den Bausteinanschlüssen beeinträchtigt wird. Außerdem kann mit diesem Konzept das Herstellungsverfahren von der Leiterplatte und vom Kühlkörper voneinander unabhängig sein. Darüber hinaus kann der Kühlkörper konstruktiv so ausgeführt werden, daß auch eine eventuelle Leiterplattenwölbung bei der Montage beseitigt wird. Durch die getrennte Konstruktion ist es besonders einfach, die Dichtigkeit des Kühlsystems zu gewährleisten.

Nach einer Weiterbildung der Erfindung ist die Lage der Bausteine bezüglich der Oberfläche der Leiterplatte durch den Kühlkörper einstellbar. Diese Einstellbarkeit bietet den Vorteil, daß die Verbindungstechnik zwischen Baustein und Leiterplatte wesentlich vereinfacht und erleichtert wird.

Eine besonders gute Wärmeableitung erhält man dann, wenn nach einer weiteren Ausgestaltung der Erfindung die Kühlkörper vom Kühlmedium direkt durchströmt werden. Auf diese Weise kann die Wärmeabfuhr gegenüber einer massiven Ausführung des Kühlkörpers noch erhöht werden.

Im Rahmen der Erfindung können die Kühlkörper Metallplättchen sein, die auf die Kühlplatte gut wärmeleitend aufgebracht sind. Ferner kann die Kühlplatte mit dem Kühlkörper als Einheit aus kaltverformten Kupfer hergestellt sein. Außerdem können die Kühlkörper galvanoplastisch auf die Kühlplatte aufgebracht sein.

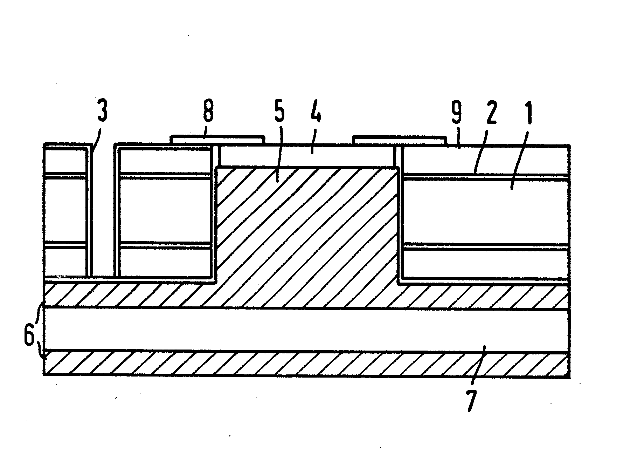

Die Erfindung wird anhand der Figur erläutert, die einen Schnitt durch eine Leiterplatte und ein Kühlsystem zeigt.

In dieser Figur ist mit 1 die Leiterplatte bezeichnet, die z. B. aus mehreren Verdrahtungsebenen 2 aufgebaut sein kann. Die einzelnen Verdrahtungsebenen können über Durchkontaktierungen 3 miteinander elektrisch verbunden sein. Mit 4 ist ein elektronischer Baustein, z. B. ein Chip, bezeichnet, der auf einem Kühlkörper 5 befestigt ist. Der Kühlkörper ist Bestandteil einer Kühlplatte 6, durch die ein Kühlmedium 7 geleitet wird. Das Kühlmedium kann auch durch den Kühlkörper strömen. Mit 8 ist die elektrische Verbindung des Bauteils mit der Leiterplatte bezeichnet.

Die Leiterplatte und das Kühlystem können getrennt hergestellt werden. Bei der Montage von Leiterplatte und Kühlsystem kann - wie bereits ausgeführt - eine Wölbung der Leiterplatte ausgeglichen werden. Durch die Höhe des Kühlkörpers und/oder die Anordnung des Kühlsystems zur Leiterplatte ist eine Verstellbarkeit der Lage der Bausteine zur Oberfläche 9 der Leiterplatte möglich. Mit einem Längenausgleichsknie im Bausteinanschluß 8 können auftretende Spannungen kompensiert werden.

7 Patentansprüche
1 Figur

Patentansprüche.

1. Kühlkonzept für elektronische Bausteine mit hohen Verlustleistungen in Verbindung mit Leiterplatten, d a d u r c h g e k e n n z e i c h n e t , daß für die zu kühlenden elektronischen Bausteine (4) Durchbrüche mindestens in der Größe von der Fläche der Bausteine in der Leiterplatte (1) vorgesehen sind, daß in diese Durchbrüche Kühlkörper (5) hineinragen, die Bestandteil einer flüssigkeits- oder gasgekühlten Kühlplatte (6) sind, und daß ferner die Bausteine gut wärmeleitend ganzflächig mit dem Kühlkörper verbunden sind.

2. Kühlkörper nach Anspruch 1, d a d u r c h g e k e n n z e i c h n e t , daß die Lage der Bausteine (4) bezüglich der Oberfläche (9) der Leiterplatte (1) durch den Kühlkörper (5) einstellbar ist.

3. Kühlkonzept nach Anspruch 1 und 2, d a d u r c h g e k e n n z e i c h n e t , daß die Bausteinanschlüsse (8) mit einem Längenausgleichsknie versehen sind.

4. Kühlkonzept nach Anspruch 1 bis 3, d a d u r c h g e k e n n z e i c h n e t , daß die Kühlkörper (5) vom Kühlmedium (7) direkt durchströmt werden.

5. Kühlkonzept nach Anspruch 1 bis 4, d a d u r c h g e k e n n z e i c h n e t , daß die Kühlkörper (5) Metallplättchen sind, die auf die Kühlplatte (6) gut wärmeleitend aufgebracht sind.

6. Kühlkonzept nach Anspruch 1 bis 4, d a d u r c h g e k e n n z e i c h n e t , daß die Kühlplatte (6) mit dem Kühlkörper (5) als Einheit aus kaltverformten Kupfer hergestellt ist.

7. Kühlkonzept nach Anspruch 1 bis 4, d a d u r c h

g e k e n n z e i c h n e t , daß die Kühlkörper (5)
galvanoplastisch auf die Kühlplatte (6) aufgebracht sind.

Europäisches
Patentamt

**EUROPÄISCHER RECHERCHENBERICHT**

0080156
Nummer der Anmeldung

EP 82 11 0599

| | **EINSCHLÄGIGE DOKUMENTE** | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
| X | IBM TECHNICAL DISCLOSURE BULLETIN, Band 19, Nr. 2, Juli 1976, Seiten 412-413, New York, USA<br>W.B. ARCHEY: "Water cooling plate for card-on-board packages" * Seiten 412-413 *<br><br>--- | 1,4,6 | H 05 K 7/20 |
| X | GB-A-1 178 566 (IBM)<br><br>* Seite 2, Zeilen 62-100; Seite 3, Zeilen 14-40; Seite 4, Zeilen 50-62; Abbildungen 2,3 *<br><br>--- | 1,2,4, 6 | |
| X | US-A-3 936 866 (NORTHROP CO.) * Spalte 1, Zeilen 55-65; Spalte 2, Zeilen 10-14; Spalte 2, Zeile 60 - Spalte 3, Zeile 3; Spalte 3, Zeilen 12-46; Abbildungen 3-7 *<br><br>--- | 1,2,7 | |
| A | US-A-3 753 056 (TEXAS INSTRUMENTS)<br><br>--- | 3 | RECHERCHIERTE SACHGEBIETE (Int. Cl. ³)<br><br>H 05 K |
| X | DE-A-2 061 603 (DIACON INC.) * Seite 10, Absatz 2 *<br><br>----- | 3 | |

Der vorliegende Recherchenbericht wurde für alle Patentansprüche erstellt.

| Recherchenort DEN HAAG | Abschlußdatum der Recherche 25-02-1983 | Prüfer SCHUERMANS N.F.G. |
|---|---|---|